# EUROPEAN PATENT APPLICATION

(11) **EP 4 525 039 A1**
(43) Date of publication of application: **19.03.2025**
(21) Application number: 24199988.7
(22) Date of filing: 12.09.2024
(51) Int. Cl.: H01L 23/528, H01L 23/532, H01L 21/768

(54) **SEMICONDUCTOR WAFER FABRICATION WITH EXPOSURE DEFINED GRAPHENE FEATURES**

(30) Priority: 18.09.2023 US 202318369757
(71) Applicant: NXP USA, Inc., Austin TX 78735 (US)
(72) Inventor: Reber, Douglas Michael, 5656AG Eindhoven (NL)
(74) Representative: Hardingham, Christopher Mark

(57) **Abstract**

A back-end-of-line integrated circuit is formed on an integrated circuit structure having one or more polymer interlayer dielectric (ILD) layers formed over a first conductive wiring line layer by selectively processing an exposed portion of the one or more polymer ILD layers with application irradiation from a laser or light source to form a graphene interconnect structure in the one or more polymer ILD layers which is directly, electrically connected to the first conductive wiring line layer.

## Description

### BACKGROUND OF THE INVENTION

### Field of the Invention

The present disclosure is directed in general to the field of semiconductor devices. In one aspect, the present disclosure relates to inter-level interconnect structures formed on semiconductor devices.

### Description of the Related Art

Modern integrated circuits typically have conductors formed on multiple interconnect layers or levels to accommodate dense circuitry. These conductors can be used to transfer information in the form of signals sent to and from integrated circuitry formed on an underlying substrate. After forming the integrated circuitry on the substrate during Front-End of Line (FEOL) processing, existing semiconductor wafer fabrication techniques form inter-level interconnect structures by repetitively performing deposit, etch, plating and polishing steps with a variety of different layers and materials, all of which make the interconnect fabrication process complex, time-consuming and expensive. In recent years, copper has been used to form inter-layer interconnects, but as semiconductor fabrication processes advance toward future nodes with shrinking interconnect stacks, there are increasingly resistance and capacitance issues which arise with the materials used to form interconnects. In addition, with higher performance demands, signals traversing the interconnect conductors operate at very high frequencies, but the smaller spacing between interconnect geometries can cause increased parasitic capacitance which adversely impacts the speed and power of integrated circuits. Another negative aspect of increased parasitic capacitance can be increased signal crosstalk between adjacent and parallel conductors. Thus, existing interconnect fabrication processes have not provided the cost, speed, and electrical performance required for leading edge integrated circuit devices. Further limitations and disadvantages of conventional processes and technologies will become apparent to one of skill in the art after reviewing the remainder of the present application with reference to the drawings and detailed description which follow.

### BRIEF DESCRIPTION OF THE DRAWINGS

The present invention may be understood, and its numerous objects, features and advantages obtained, when the following detailed description of a preferred embodiment is considered in conjunction with the following drawings.
Figures 1-8 illustrate cross-sectional views at different stages of manufacture of a semiconductor structure having graphene interconnect structures formed using photosensitive polymer interlayer dielectric layers in a selective polyimide-to-graphene conversion process in accordance with selected embodiments of the present disclosure.
Figures 9-14 illustrate cross-sectional views at different stages of manufacture of a semiconductor structure having graphene interconnect structures formed using non-photosensitive polymer interlayer dielectric layers in a selective polyimide-to-graphene conversion process in accordance with selected embodiments of the present disclosure.
Figure 15 illustrates an example plan view of via-connected conductive interconnect layers which are made in accordance with conventional fabrication processes.
Figure 16 illustrates an example plan view of via-connected conductive interconnect layers made in accordance with selected embodiments of the present disclosure.
Figure 17 illustrates a simplified process flow for fabricating graphene interconnect structures in accordance with selected embodiments of the present disclosure.

### DETAILED DESCRIPTION

An integrated circuit fabrication process and resulting integrated circuit are described for fabricating conductive interconnect structures with exposure-defined graphene features formed using a selective polyimide-to-graphene conversion process so that via levels can be formed from the complete union of the overlapping portions of the interconnect layers being interconnected, thereby significantly increasing the interconnect conductivity. In selected embodiments, a photosensitive polyimide dielectric layer is formed over a semiconductor wafer to cover a plurality of integrated circuits, and then covered with one or more patterned photoresist layers or masks so that a light source may be selectively applied to convert one or more exposed portions of the photosensitive polyimide dielectric layer into an interconnect precursor structure which is exposed to a Nickel solution soak and then heat treated to convert the interconnect precursor structure into a graphene interconnect structure. In other embodiments, a non-photosensitive, carbon-containing polyimide dielectric layer is formed to cover a plurality of integrated circuits on a semiconductor wafer, and then covered with one or more patterned photoresist layers so that a laser light source may be selectively applied to directly convert one or more exposed portions of the non-photosensitive, carbon-containing polyimide dielectric layer into a graphene foam interconnect structure. For example, a laser ranging from infrared, ultraviolet, or visible ranges may be employed to directly lase one or more carbon-containing polyimide dielectric film layers into 3D porous graphene material as a one-step method without the need for high-temperature reaction conditions, solvent, or subsequent treatments. By directly forming graphene foam interconnect structures from the carbon-containing polyimide dielectric layer(s) using a laser energy source, no additional barrier layers or liner layers are required, such as are used with nickel or copper-based interconnects.

In this disclosure, an improved integrated circuit design, structure, and method of manufacture are described for forming graphene interconnect structures as part of the middle-end-of-line or back-end-of-line process to address various problems in the art where various limitations and disadvantages of conventional solutions and technologies will become apparent to one of skill in the art after reviewing the remainder of the present application with reference to the drawings and detailed description provided herein. Various illustrative embodiments of the present invention will now be described in detail with reference to the accompanying figures. While various details are set forth in the following description, it will be appreciated that the present invention may be practiced without these specific details, and that numerous implementation-specific decisions may be made to the invention described herein to achieve the device designer's specific goals, such as compliance with process technology or design-related constraints, which will vary from one implementation to another. While such a development effort might be complex and time-consuming, it would nevertheless be a routine undertaking for those of ordinary skill in the art having the benefit of this disclosure. For example, selected aspects are depicted with reference to simplified cross sectional drawings of a semiconductor device without including every device feature or geometry in order to avoid limiting or obscuring the present invention. Such descriptions and representations are used by those skilled in the art to describe and convey the substance of their work to others skilled in the art. It is also noted that, throughout this detailed description, certain elements in the figures are illustrated for simplicity and clarity and have not necessarily been drawn to scale. In addition, the dimensions of some of the elements in the figures may be exaggerated relative to other elements to help improve the understanding of the embodiments of the present disclosure. Further, reference numerals have been repeated among the drawings to represent corresponding or analogous elements. In addition, the depicted device layers that are shown as being deposited and/or etched are represented with simplified line drawings, though it will be appreciated that, in reality, the actual contours or dimensions of device layers will be non-linear, such as when the described etch processes are applied at different rates to different materials, or when the described deposition or growth processes generate layers based on the underlaying materials.

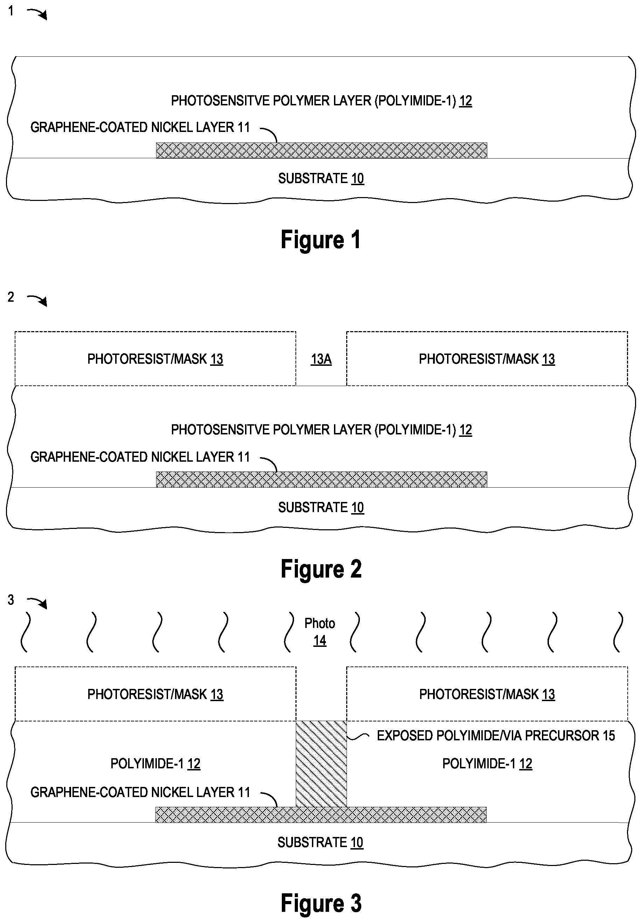

Various illustrative embodiments of the present invention will now be described in detail with reference to Figures 1-17. In addition, although specific example materials, thicknesses, and processes are described herein, those skilled in the art will recognize that other materials, thicknesses, and processes with similar properties or characteristics can be substituted without loss of function. It is noted that, throughout this detailed description, certain layers of materials will be deposited and removed to form the semiconductor structure. Where the specific procedures for processing such layers or thicknesses of such layers are not detailed below, conventional techniques known to one skilled in the art for depositing, removing, forming, or otherwise processing such layers at appropriate thicknesses shall be intended. Such details are well known and not considered necessary to teach one skilled in the art how to make or use the present invention.

For an improved understanding of selected embodiments of the present disclosure, reference is now made to Figures 1-8 which illustrate cross-sectional views at different stages of manufacture of a semiconductor structure having graphene interconnect structures formed using photosensitive polymer interlayer dielectric layers in a selective polyimide-to-graphene conversion process. In particular, Figure 1 illustrates in cross-sectional form a portion of a semiconductor structure 1 having a first photosensitive polymer layer 12 and a graphene-coated nickel layer 11 formed over a substrate 10 in which one or more integrated circuit elements (not shown) are formed. As will be appreciated, the integrated circuit elements may include one or more transistors, resistors, capacitors, diodes, or other semiconductor components that are formed on or in a semiconductor substrate that can be formed with any suitable semiconductor material or combinations of materials, such as gallium arsenide, silicon germanium, semiconductor-on-insulator (SOI), silicon, monocrystalline silicon, and the like. To protect the integrated circuit elements, the substrate 10 also includes an initial insulating layer (not shown) which may be formed with any suitable insulating material. For example, a planarized boro-phosphorous tetra-ethyl ortho-silicate (BPTEOS) layer may form all or part of an initial inter-layer dielectric (ILD0) layer that provides a gettering function to help protect integrated circuit elements and to control the field leakage between semiconductor transistors.

After forming the initial ILD0 layer, the graphene-coated nickel layer 11 may be formed as the first metal line (M1) conductor layer using any suitable graphene coating technique. For example, the graphene-coated nickel layer 11 may be formed with nickel or other suitable metal material which is exposed to a growth process using a carbon-containing film, such as acetylene or other carbon-containing gas, to form a graphene coating layer that surrounds the patterned nickel layer. The carbon-containing gas may be part of a plasma, remote plasma, or chemical reaction process such that elemental carbon or carbon ions interact with the nickel. As the carbon diffuses through the nickel, it forms graphene on the outer surfaces of the nickel until such time as the carbon reaches its solid solubility limit in nickel. Excess carbon, which may not be in graphene form, such as graphite, is removed chemically, such as with the use of a plasma etch. Alternatively, to form the graphene-coated nickel layer 11, a patterned nickel layer may be exposed to a plasma with some hydrogen and controlled amounts of methane, or may be exposed to a carbon-containing paste. Alternatively, the graphene-coated nickel layer 11 may be formed as a graphene foam layer by using a laser-induced graphene technique described more fully hereinbelow to convert a polyimide layer directly into graphene without requiring a patterned metal layer.

After forming the graphene-coated nickel layer 11, the first photosensitive polymer layer 12 may be formed with a photosensitive polyimide over the semiconductor structure to a predetermined thickness using any suitable deposition technique, such as spin-on deposition, chemical vapor deposition (CVD), plasma-enhanced chemical vapor deposition (PECVD), physical vapor deposition (PVD), atomic layer deposition (ALD), atmospheric pressure CVD (AP-CVD), chemical bath deposition (CBD), or any combination(s) of the above. For example, the first polymer dielectric layer 12 may be formed with any suitable photosensitive engineering plastic or polyimide materials which are imparted with photosensitivity by chemical modification of molecular structure of a polyimide or poly(amic acid) as a polyimide precursor, or by addition of low-molecular-weight additives (sensitizer, photoacid generator, photo-radical generator, etc.) to a chemically modified polyimide or poly(amic acid). In other embodiments, the first photosensitive polymer layer 12 may be formed with any suitable ultra-low-k (ULK) photo-imageable polymer. As understood by those skilled in the art, a photoimagable ULK dielectric material has a dielectric constant k value of less than about 2.5, and responds to light exposure with a chemical reaction which is then used for an ion exchange to impregnate a suitable metal (e.g., Cu, Ni, Co, Pd, Pt) into the photosensitive polymer layer 12. These metal catalysts are used to reduce the temperature at which graphene is created through solid phase-solubility reactions.

Figure 2 illustrates processing of the semiconductor structure 2 subsequent to Figure 1 after forming a first patterned photoresist or hard mask layer 13 on the semiconductor structure in accordance with selected embodiments of the present disclosure. While any suitable photoresist patterning process may be used, the first patterned photoresist mask 13 may be formed on the first photosensitive polymer layer 12 by depositing, patterning, etching or developing a photoresist layer formed with any material that is suitable for photolithography. For example, a first patterned photoresist layer 13 may be formed by coating the first photosensitive polymer layer 12 with a light-sensitive organic material, applying a light source with a patterned mask over the surface of the wafer substrate which blocks light so that only unmasked regions of the material will be exposed to light, and applying a solvent to develop the material so that photo-sensitive material degraded by light and the developer will dissolve away the regions that were exposed to light, leaving behind a coating where the mask was placed and an via etch opening over the first patterned photoresist or hard mask layer 13 where the coating is removed. As depicted, the first patterned photoresist or hard mask layer 13 includes a defined opening 13A which exposes the underlying first photosensitive polymer layer 12 at an intended etch location for forming a via etch opening over the depicted graphene-coated nickel layer 11. As indicated with the dashed lines, the first patterned photoresist or hard mask layer 13 may not be required in embodiments where laser direct writing is subsequently used to transform selected portions of the first photosensitive polymer layer 12.

Figure 3 illustrates processing of the semiconductor structure 3 subsequent to Figure 2 after a photoirradiation light source 14 is applied to the exposed polyimide region 12, thereby creating the via precursor structure 15 in accordance with selected embodiments of the present disclosure. While any suitable photoirradiation light source 14 may be used, an ultraviolet (UV) light source may use the defined opening 13A in the first patterned photoresist mask 13 to define the location of the via precursor structure 15 to make direct contact with the underlying graphene-coated nickel layer 11. In yet other embodiments, the photoirradiation light source 14 may be replaced with a suitable laser source which has its laser scanning operations controlled to apply a set of laser pulses which are positioned with sufficient energy to convert the exposed first photosensitive polymer layer 12 into the via precursor structure 15. While the sidewalls of the precursor structure 15 are substantially vertical, it will be appreciated that minor deviations in the sidewall profile may occur due to processing variations.

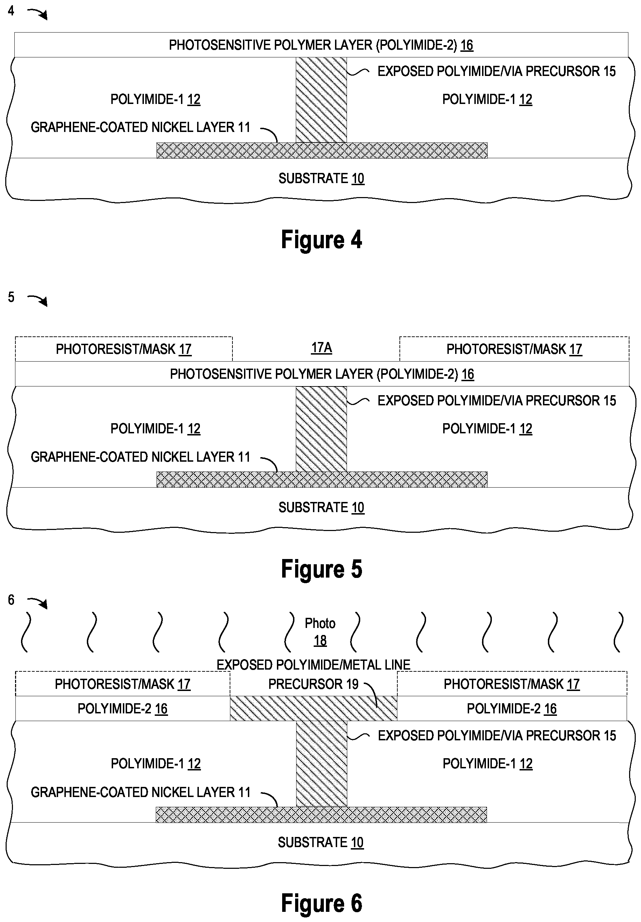

Instead of developing or removing the via precursor structure 15, an additional photosensitive polymer layer is deposited and processed to form a metal line precursor structure in direct contact with the via precursor structure 15. To this end, Figure 4 illustrates processing of the semiconductor structure 4 subsequent to Figure 3 after forming a second photosensitive polymer layer 16 on the first photosensitive polymer layer 12 and via precursor structure 15. Prior to forming the second photosensitive polymer layer 16, the first patterned photoresist layer 13 may be stripped or removed. As disclosed herein, the second photosensitive polymer layer 16 may be formed with a photosensitive polyimide over the semiconductor structure to a predetermined thickness using any suitable deposition technique. For example, the second polymer dielectric layer 16 may be formed with any suitable photosensitive engineering plastic or polyimide materials which are imparted with photosensitivity by chemical modification of molecular structure of a polyimide or poly(amic acid) as a polyimide precursor, or by addition of low-molecular-weight additives (sensitizer, photoacid generator, photo-radical generator, etc.) to a chemically modified polyimide or poly(amic acid). In other embodiments, the second polymer dielectric layer 16 may be formed with any suitable ultra-low k photo-imageable polymer which responds to light exposure with a chemical reaction which is then used for an ion exchange to impregnate a suitable metal (e.g., Cu, Ni, Co, Pd, Pt) into the photosensitive polymer layer 16.

Figure 5 illustrates processing of the semiconductor structure 5 subsequent to Figure 4 after forming a second patterned photoresist or hard mask layer 17 on the semiconductor structure in accordance with selected embodiments of the present disclosure. In selected embodiments, the second patterned photoresist or hard mask layer 17 may be formed by depositing, patterning, etching or developing a photoresist layer formed with any material that is suitable for photolithography. As depicted, the second patterned photoresist or hard mask layer 17 includes a defined opening 17A which exposes the underlying second photosensitive polymer layer 16 at an intended etch location for forming a metal line etch opening. As indicated with the dashed lines, the second patterned photoresist or hard mask layer 17 may not be required in embodiments where laser direct writing is subsequently used to transform selected portions of the second photosensitive polymer layer 16.

Figure 6 illustrates processing of the semiconductor structure 6 subsequent to Figure 5 after a photoirradiation light source 18 is applied to the exposed polyimide region 16, thereby creating the metal line precursor structure 19 from the exposed polyimide layer 16 in accordance with selected embodiments of the present disclosure. While any suitable photoirradiation light source 18 may be used, an ultraviolet (UV) light source may use the defined opening 17A in the second patterned photoresist mask 17 to define the location of the metal line precursor structure 19 to make direct contact with the underlying via precursor structure 15. In yet other embodiments, the photoirradiation light source 18 may be replaced with a suitable laser source which has its laser scanning operations controlled to apply a set of laser pulses which are positioned with sufficient energy to convert the exposed second photosensitive polymer layer 16 into the metal line precursor structure 19. While the sidewalls of the metal line structure 19 are substantially vertical, it will be appreciated that minor deviations in the sidewall profile may occur due to processing variations.

As disclosed hereinabove, the precursor structures 15, 19 may be formed with separate photosensitive polyimide layers 12, 16 using separate resist masks 13, 17. However, other embodiments of the present disclosure may apply a photoirradiation light source to a single photosensitive polyimide layer by sequentially forming separate resist masks on the single photosensitive polyimide layer.

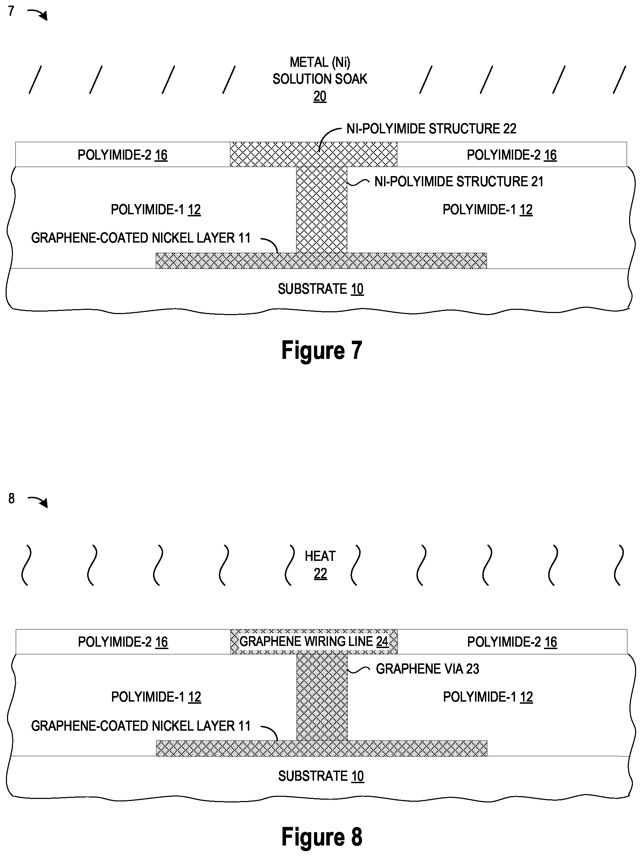

Instead of developing or removing the metal line precursor structure 22, the polyimide stack and via/metal line precursor structures are processed with a metal solution soak to form graphene interconnect structures from the via/metal line precursor structures. To this end, Figure 7 illustrates processing of the semiconductor structure 7 subsequent to Figure 6 after forming metal-polyimide structures 21, 22 by exposing the polyimide stack 12, 16 and precursor structures 15, 19 to a metal solution soak 20 in accordance with selected embodiments of the present disclosure. Prior to performing the metal solution soak 20, the second patterned photoresist layer 17 may be stripped or removed. In selected embodiments, the metal solution soak 20 may be a Nickel (Ni) solution soak wherein the acid formed by the previous light exposure step 19 results in an ion exchange which causes the Ni metal to in the solution to plate throughout the precursor structures 15, 19. After the Nickel ion replacement in the soak, the nickel adheres in the polyimide exposed areas, thereby forming Nickel-polyimide structures 21, 22. In particular, the Nickel solution soak may be used to form Nickel-polyimide structures by enabling nucleophilic substitution of a nucleophilic nickel acylate complex (or similar nucleophile) with the light-exposed polyimide materials in the precursor structures 15, 19. In other embodiments, soak solutions could be used with other nucleophilic complexes using other metals (e.g., Cu, Co, Pd, Pt... etc.).

Figure 8 illustrates processing of the semiconductor structure 8 subsequent to Figure 7 after performing a heat treatment 22 to convert the metal-polyimide structures 21, 22 into graphene structures 23, 24 in accordance with selected embodiments of the present disclosure. In selected embodiments, the heat treatment 22 may follow a multistage heating schedule where the semiconductor structure may be heated to a first temperature (T1) less than TMAX for a first time period, followed by gradually increasing or ramping-up the temperature process to TMAX, and then maintaining TMAX for a second time period, followed by a cool down period. In one embodiment, and by way of non-limiting example only, T1 may range from approximately 100 to 200° C., while TMAX is greater than T1 and ranges from approximately 170 to 280° C. The process parameters employed may be controlled to fully convert the intermixed Ni metal and polyimide from the metal-polyimide structures 21, 22 into highly conductive graphene via 23 and graphene wiring line 24.

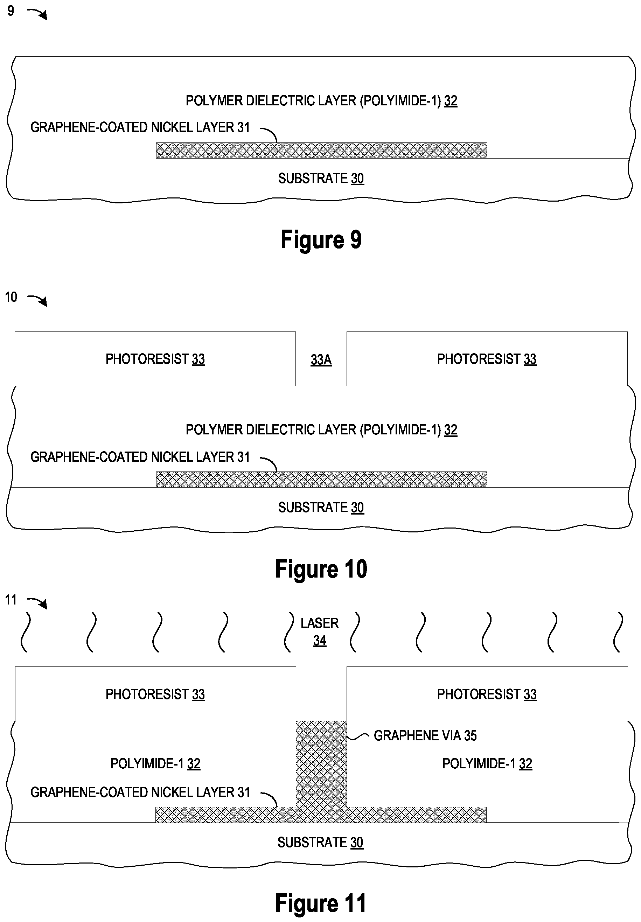

For an improved understanding of selected embodiments of the present disclosure, reference is now made to Figures 9-14 which illustrate cross-sectional views at different stages of manufacture of a semiconductor structure having graphene interconnect structures formed using non-photosensitive polymer interlayer dielectric layers in a selective polyimide-to-graphene conversion process. In particular, Figure 9 illustrates in cross-sectional form a portion of a semiconductor structure 9 having a first polymer dielectric layer 32 and a graphene-coated nickel layer 31 formed over a substrate 30 in which is formed one or more integrated circuit elements (not shown), such as transistors, resistors, capacitors, diodes, or other semiconductor components. To protect the integrated circuit elements, the substrate 30 also includes an initial insulating layer (not shown) which may be formed with any suitable insulating material. For example, a planarized boro-phosphorous tetra-ethyl ortho-silicate (BPTEOS) layer may form all or part of an initial inter-layer dielectric (ILD0) layer that provides a gettering function to help protect integrated circuit elements and to control the field leakage between semiconductor transistors.

After forming the initial ILD0 layer in the substrate 30, the graphene-coated nickel layer 31 may be formed as the first metal line (M1) conductor layer using any suitable graphene coating technique. Alternatively, the graphene-coated nickel layer 31 may be formed as a solid graphene layer by using a laser-induced graphene technique described more fully hereinbelow to convert a polyimide layer directly into graphene foam structure without requiring a patterned metal layer. Alternatively, the graphene-coated nickel layer 31 may be replaced with a patterned metal line layer that is selectively deposited, plated, or otherwise formed on the substrate 30.

After forming the graphene-coated nickel layer 11, a first polymer dielectric layer 32 may be formed over the semiconductor structure to a predetermined thickness using any suitable deposition technique, such as spin-coating, CVD, PECVD, PVD, ALD, AP-CVD, CBD, or any combination(s) of the above. For example, the first polymer dielectric layer 32 may be formed with a non-photosensitive carbon-containing polymer dielectric material or other suitable engineering plastic or polyimide material, including but not limited to fluorinated polyimide (PI-FP, PI-FO and PI-FH) films which may be prepared using a polycondensation reaction method by incorporating p-phenylenediamine (PDA), 4-40-diaminodiphenyl ether (ODA) and 4,40-(Hexafluoroisopropylidene) bis (p-phenyleneoxy) dianiline (HFPBDA) into 4,40-(Hexafluoroisopropylidene) diphthalic anhydride (6FDA), respectively. More generally, the first polyimide dielectric layer 32 is formed with a material having chemical properties which interact with laser irradiation to directly form graphene.

Figure 10 illustrates processing of the semiconductor structure 10 subsequent to Figure 9 after forming a first patterned photoresist or hard mask layer 33 on the semiconductor structure in accordance with selected embodiments of the present disclosure. In selected embodiments, the first patterned photoresist mask 33 may be formed on the first polymer dielectric layer 32 by depositing, patterning, etching or developing a photoresist layer formed with any material that is suitable for photolithography. As formed, the first patterned photoresist or hard mask layer 33 includes a defined opening 33A which exposes the first polymer dielectric layer 32 at an intended exposure location for forming a graphene via structure in the first polymer dielectric layer 32 which contacts the underlying graphene-coated nickel layer 31.

Figure 11 illustrates processing of the semiconductor structure 11 subsequent to Figure 10 after applying a laser irradiation source 34 to directly convert the portion of the first polyimide dielectric layer 32 exposed by the first patterned photoresist mask 33 into a graphene via structure 35 in accordance with selected embodiments of the present disclosure. While any suitable laser irradiation source 34 may be used, lasers ranging from infrared, ultraviolet, and visible ranges may be employed to provide a laser-induced graphene process which synthesizes the graphene via structure 35. For example, a femto-second UV laser may be employed to directly lase polyimide (PI) plastic films into 3D porous graphene material as a one-step method without the need for high-temperature reaction conditions, solvent, or subsequent treatments. As disclosed herein, the application of the laser irradiation source 34 should be controlled to selectively apply the required energy dosage for converting the exposed portion of the first polyimide dielectric layer 32 into the graphene via structure 35.

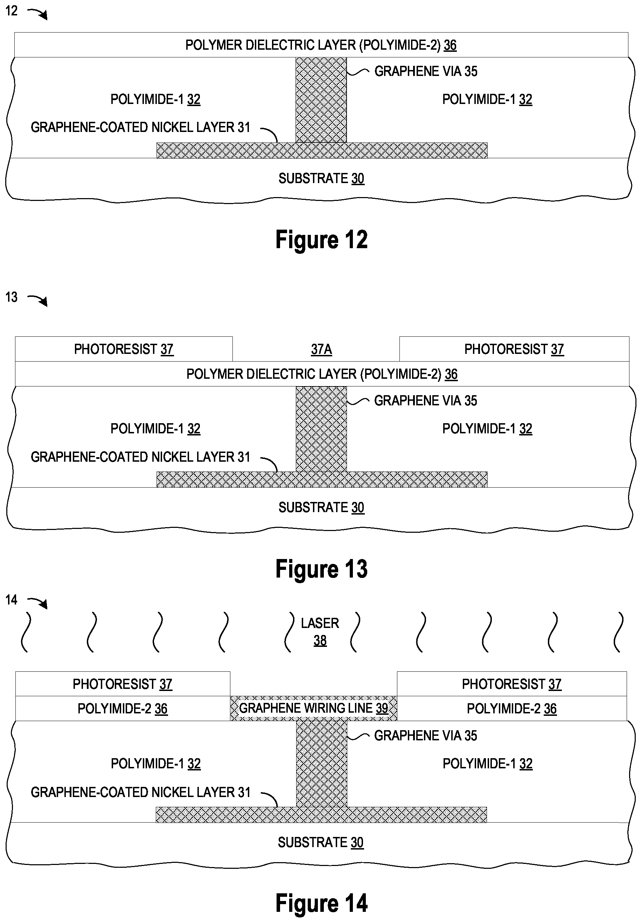

Figure 12 illustrates processing of the semiconductor structure 12 subsequent to Figure 11 after forming a second polymer dielectric layer 36 on the first polymer dielectric layer 32 and graphene via structure 35. After stripping or removing the first patterned photoresist layer 33, the second polymer dielectric layer 36 may be formed over the semiconductor structure to a predetermined thickness using any suitable deposition technique. For example, the second polymer dielectric layer 36 may be formed with a non-photosensitive, carbon-containing polymer dielectric material or other suitable engineering plastic or polyimide material, including but not limited to fluorinated polyimide (PI-FP, PI-FO and PI-FH) films which may be prepared using a polycondensation reaction method by incorporating p-phenylenediamine (PDA), 4-40-diaminodiphenyl ether (ODA) and 4,40-(Hexafluoroisopropylidene) bis (p-phenyleneoxy) dianiline (HFPBDA) into 4,40-(Hexafluoroisopropylidene) diphthalic anhydride (6FDA), respectively. More generally, the second polymer dielectric layer 36 may be formed with a material having chemical properties which interact with laser irradiation to directly form graphene.

Figure 13 illustrates processing of the semiconductor structure 13 subsequent to Figure 12 after forming a second patterned photoresist or hard mask layer 37 on the semiconductor structure in accordance with selected embodiments of the present disclosure. In selected embodiments, the second patterned photoresist or hard mask layer 37 may be formed by depositing, patterning, etching or developing a photoresist layer formed with any material that is suitable for photolithography. As formed, the second patterned photoresist or hard mask layer 37 includes a defined opening 37A which exposes the underlying second polymer dielectric layer 36 at an intended exposure location for forming a graphene wiring line structure in at least the second polymer dielectric layer 36 which contacts the underlying graphene via structure 35.

Figure 14 illustrates processing of the semiconductor structure 14 subsequent to Figure 13 after applying a laser irradiation source 38 to directly convert the portion of the second polyimide dielectric layer 36 exposed by the second patterned photoresist mask 37 into a graphene wiring line structure 39 in accordance with selected embodiments of the present disclosure. While any suitable laser irradiation source 38 may be used, a femto-second UV laser may be employed to directly lase polyimide (PI) plastic films into 3D porous graphene material as a one-step method without the need for high-temperature reaction conditions, solvent, or subsequent treatments. As disclosed herein, the application of the laser irradiation source 38 should be controlled to selectively apply the required energy dosage for converting the exposed portion of at least the second polyimide dielectric layer 36 into the graphene wiring line structure 39.

As disclosed hereinabove, the graphene via structure 35 and graphene wiring line structure 39 may be formed with separate non-photosensitive polyimide layers 32, 36 using separate resist masks 33, 37. However, other embodiments of the present disclosure may apply a laser irradiation source to a single polyimide dielectric layer (e.g., 32) by sequentially forming separate resist masks on the single polyimide dielectric layer. In such embodiments where the intended graphene via structure 35 and metal line structure 39 have different depth profiles, the application of the laser irradiation source should be controlled to selectively apply the required energy dosage for converting the single polyimide dielectric layer into the graphene interconnect structures 35, 39. For example, the laser scanning operations may be controlled to apply a first set of laser pulses which are positioned with sufficient energy to convert the entirety of the single polyimide dielectric layer at a first exposed location into the graphene via structure 35, and to apply a second set of laser pulses which are positioned with sufficient energy to convert an upper portion of the single polyimide dielectric layer at a second exposed location into the graphene wiring line structure 39. By properly constructing the polyimide dielectric layers 32, 36 with a material that is not photosensitive, but is reactive to one or more laser irradiation sources, the graphene interconnect structures 35, 39 may be selectively formed in the semiconductor structure to provide reduced electrical resistivity and processing complexity as compared to existing techniques which use metal conductors (e.g., copper or nickel) to form the conductive interconnect structures.

As will be appreciated, the graphene interconnect fabrication sequence described hereinabove may be repeated one or more times to form multiple graphene interconnect layers or levels over the substrate. For example, a second graphene interconnect structure may be formed in one or more additional polyimide dielectric layers forming a second inter-layer dielectric (ILD2) layer that is formed on the first ILD1 layer by selectively applying a laser irradiation source to convert exposed portions of the additional polyimide dielectric layers into the second graphene wiring interconnect structure.

The last or topmost metal layers in the semiconductor structure can be formed with any conductive material, such as laser-induced graphene, aluminum, copper, tantalum, tungsten, tantalum nitride, tungsten nitride, titanium, titanium nitride, or the like and combinations of the above. As formed, each of the last metal layers is coupled to one or more integrated circuit elements (not shown) in the substrate via the intervening graphene interconnect structures (e.g., 35, 39) formed within ILD layers of an interconnect stack which may be formed with any suitable polyimide dielectric layers. While the specific arrangement, construction, and connection of the different conductive interconnect layers is not important, each may be constructed within a constituent polyimide dielectric layer in the interconnect stack by using a masked laser irradiation source to directly convert the polyimide dielectric layer(s) into graphene interconnect structures as disclosed herein.

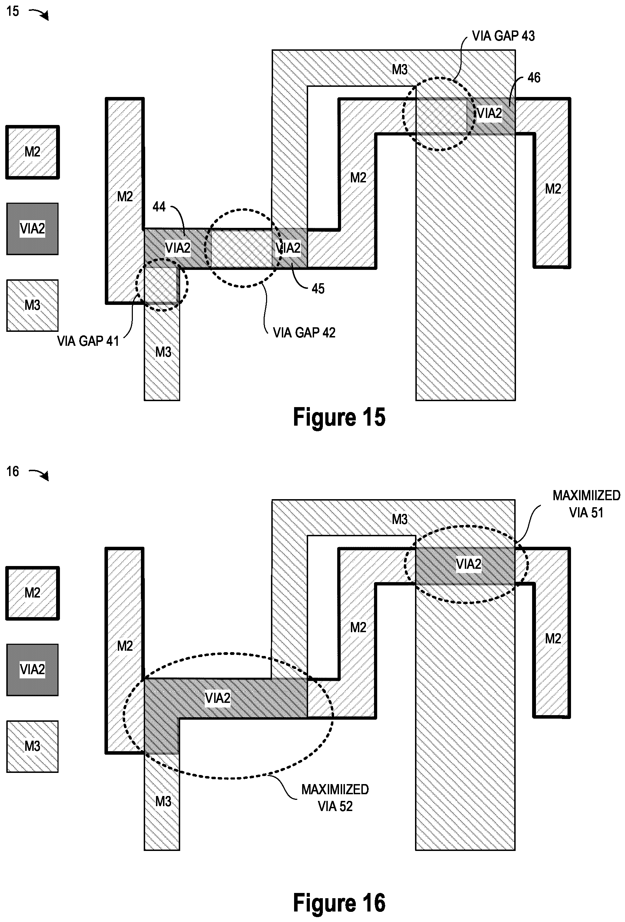

For an improved contextual understanding of the present disclosure, reference is now made to Figure 15 which illustrates an example plan view 15 of a conductive interconnect stack wherein metal line layers M2, M3 are connected together by via structures VIA2 which are made in accordance with conventional fabrication processes. In particular, the bottom metal line layer M2 extends across a first defined path which is positioned below the upper metal line layer M3 which extends across a second defined path. At selected overlap points between the metal line layers M2, M3, one or more via structures VIA2 are formed. Unfortunately, conventional fabrication tools restrict each of the via structures VIA2 to having a predetermined or defined shape, such as a circle or a rectangle. In addition, there are placement constraints which prevent two or more via structures VIA2 from being placed directly adjacent to one another. For example, there are lateral spacing constraints that arise from existing patterned mask and etch tools which prevent the via gaps 41-43 from being filled with an additional via structure VIA2 since it would be adjacent or overlapping with the via structures VIA2 44-46.

For an improved understanding of selected embodiments of the present disclosure, reference is now made to Figure 16 which illustrates an example plan view 16 of a conductive interconnect stack wherein metal line layers M2, M3 are connected together by maximized via structures VIA2. Again, the bottom metal line layer M2 extends across a first defined path which is positioned below the upper metal line layer M3 which extends across a second defined path. However, by using one or more photoresist masks to selectively apply laser irradiation which directly converts one or more polyimide layers into graphene via structures that are located at the overlapping regions between the bottom metal line layer M2 and the upper metal line layer M3, the resulting laser-defined via structures VIA2 51, 52 provide maximized via connection between the metal line layers M2, M3, thereby improving the electrical conductivity of the conductive interconnect stack.

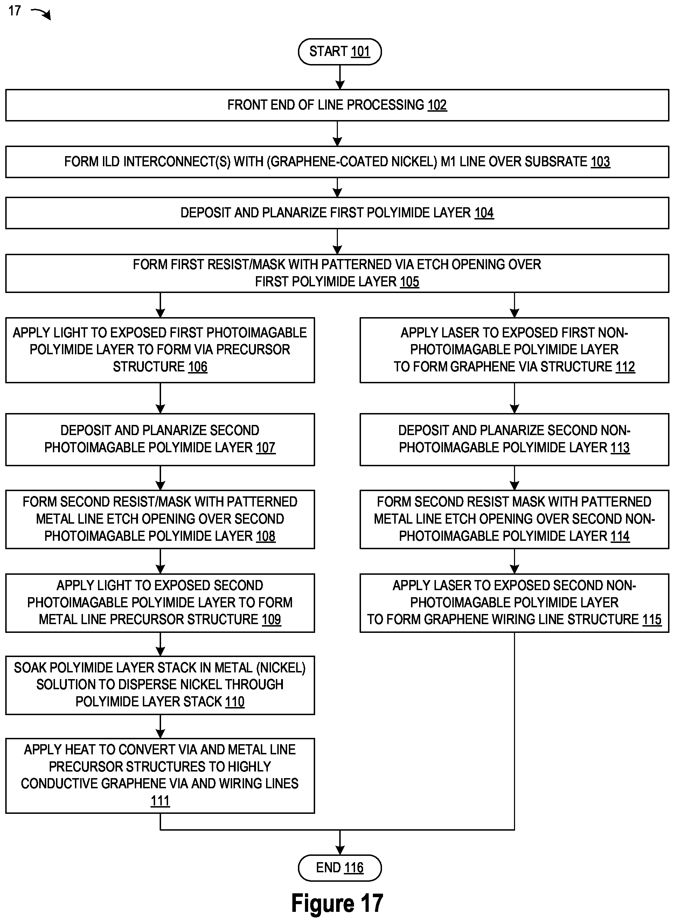

Turning now to Figure 17, there is illustrated a simplified process flow 17 for fabricating a graphene interconnect structure in accordance with selected embodiments of the present disclosure. Though described herein with reference to an example back-end-of-line fabrication process, it will be appreciated by persons skilled in the art that the sequence of illustrated steps may be used in any suitable stage of the device fabrication process, and may be modified, reduced or augmented in keeping with the disclosure of the present invention. Thus, it will be appreciated that the methodology of the present disclosure may be thought of as performing the identified sequence of steps in the order depicted in Figure 17, though the steps may also be performed in parallel, in a different order, or as independent operations that are combined.

After starting at step 101, the disclosed fabrication methodology begins with one or more front-end-of-line (FEOL) processing steps 102 which are used to fabricate one or more integrated circuit elements (e.g., transistors, capacitors, resistors, diodes, etc.) in a wafer substrate. Generally speaking, FEOL processing is the first portion of IC fabrication where the individual components (transistors, capacitors, resistors, etc.) are patterned in the semiconductor, and generally covers everything up to (but not including) the deposition of conductive interconnect layers.

At step 103, one or more first ILD interconnects are formed over the wafer substrate with an attached first metal (M1) line. An example first ILD interconnect may include an initial interlayer dielectric (ILD0) layer that is formed over the integrated circuit elements by depositing, spin-coating, or otherwise forming a silicon dioxide layer. In the initial ILD0 layer, a contact may be formed to extend through the initial ILD0 layer to a terminal of an integrated circuit element (e.g., a source/drain region of a transistor device), such as be selectively etching a contact opening and then filling the opening with one or more conductive via layers. In contact with the contact, a first metal (M1) layer may be selectively formed over the initial ILD0 layer, such as by depositing a conductive metal layer over the wafer substrate that is subsequently patterned and etched to leave the M1 layer. In other embodiments, the M1 layer may be formed by selectively etching a metal line etch opening in the initial ILD0 layer, filling the metal line etch opening with one or more polyimide layers, and then selectively applying a laser beam at the appropriate energy dose and intensity to directly convert the one or more polyimide layers into a graphene M1 metal line layer. In other embodiments, the M1 layer may be formed as a graphene-coated nickel layer using any suitable graphene coating technique.

At step 104, a first polyimide layer is deposited and planarized over the wafer substrate. An example polyimide layer may be formed with a photosensitive polymer dielectric material having a dielectric constant k value of less than about 2.5 that is formed to a predetermined thickness using any suitable deposition technique, such as CVD, PECVD, PVD, ALD, AP-CVD, CBD, or any combination(s) of the above. Example photosensitive polymer dielectric materials include, but are not limited to, photosensitive engineering plastic or polyimide materials, which are imparted with photosensitivity by chemical modification of molecular structure of a polyimide or poly(amic acid) as a polyimide precursor, or by addition of low-molecular-weight additives (sensitizer, photoacid generator, photo-radical generator, etc.) to a chemically modified polyimide or poly(amic acid). In other embodiments, the first polyimide layer may be formed with a non-photosensitive, carbon-containing polymer dielectric which responds to laser irradiation to directly form graphene. Examples of non-photosensitive carbon-containing polymer dielectric materials include, but are not limited to, fluorinated polyimide (PI-FP, PI-FO and PI-FH) films which may be prepared using a polycondensation reaction method by incorporating p-phenylenediamine (PDA), 4-40-diaminodiphenyl ether (ODA) and 4,40-(Hexafluoroisopropylidene) bis (p-phenyleneoxy) dianiline (HFPBDA) into 4,40-(Hexafluoroisopropylidene) diphthalic anhydride (6FDA), respectively.

At step 105, a first photoresist and/or mask layer is formed over the first polyimide layer with a patterned via etch opening which exposes a portion of the first polyimide layer. In selected embodiments, the first photoresist mask is formed by coating the first polyimide layer with a light-sensitive organic material, applying a light source with a patterned mask over the surface of the wafer substrate which blocks light so that only unmasked regions of the material will be exposed to light, and applying a solvent to develop the material so that photo-sensitive material degraded by light and the developer will dissolve away the regions that were exposed to light, leaving behind a coating where the mask was placed and an via etch opening over the first polyimide layer where the coating is removed.

In selected embodiments where the first polymer layer is a first photoimagable polyimide layer, a sequence of graphene interconnect fabrication steps continues with step 106 by selectively applying light to a portion of the first photoimagable polyimide layer exposed by the first photoresist mask, thereby forming a via precursor structure in the first photoimagable polyimide layer. In selected embodiments, the via precursor structure extends through the entirety of the first photoimagable polyimide layer to make contact with the M1 layer.

At step 107, a second photoimagable polyimide layer is formed over the semiconductor structure after removing the first photoresist mask. An example second photoimagable polyimide layer may be formed with any suitable high-performance polymer material having optical and dielectric properties such that the polymer material responds to light exposure with a chemical reaction which allows for an ion-exchange reaction with Nickel (or other suitable metal catalyst for graphene creation). In selected embodiments, the second photoimagable polyimide layer may be deposited using any suitable deposition technique (e.g., CVD, PECVD, PVD, ALD, AP-CVD, CBD, or any combination(s) of the above) to a predetermined thickness, and may then be planarized by applying CMP or other planarization step to the second photoimagable polyimide layer.

At step 108, a second photoresist and/or mask layer is formed over the second photoimagable polyimide layer with a patterned metal line etch opening which exposes a portion of the second photoimagable polyimide layer. In selected embodiments, the second photoresist mask is formed with any suitable photoresist/mask formation sequence.

At step 109, light is selectively applied to a portion of the second photoimagable polyimide layer exposed by the second photoresist mask, thereby forming a metal line precursor structure in the second photoimagable polyimide layer. In selected embodiments, the metal line precursor structure extends down through at least the second photoimagable polyimide layer to make contact with the via precursor structure.

At step 110, a metal soak solution is applied to the polyimide layer stack, including the first and second photoimagable polyimide layers and the via and metal line precursor structures. In selected embodiments, the metal soak solution is a Nickel (Ni) solution soak wherein the acid formed by the previous light exposure steps (steps 106, 109) causes the Ni metal to in the solution to plate throughout the via/metal line precursor structures to form Nickel-polyimide structures by enabling nucleophilic substitution of a nucleophilic nickel acylate complex (or similar nucleophile) with the light-exposed polyimide materials in the precursor structures.

At step 111, a heat treatment step is applied to convert the via and metal line precursor structures into highly conductive graphene via and wiring lines. In selected embodiments, the heat treatment step may apply a specified thermal heat budget so that intermixed Nickel metals and polyimide material in the via/metal line precursor structures are converted to graphene via and wiring line conductors.

In selected embodiments where the first polymer layer is a first non-photoimagable polyimide layer, the sequence of graphene interconnect fabrication steps continues with step 112 by selectively applying a laser irradiation source to a portion of the first non-photoimagable polyimide layer exposed by the first photoresist mask, thereby directly forming a graphene via structure in the first non-photoimagable polyimide layer. In selected embodiments, the graphene via structure extends through the entirety of the first non-photoimagable polyimide layer to make contact with the M1 layer.

At step 113, a second non-photoimagable polyimide layer is formed over the semiconductor structure after removing the first photoresist mask. An example second non-photoimagable polyimide layer may be formed with any suitable high-performance polymer material, including but not limited to, fluorinated polyimide (PI-FP, PI-FO and PI-FH) films, which have optical and dielectric properties such that the polymer material responds to laser irradiation to directly form graphene. In selected embodiments, the second non-photoimagable polyimide layer may be deposited using any suitable deposition technique (e.g., CVD, PECVD, PVD, ALD, AP-CVD, CBD, or any combination(s) of the above) to a predetermined thickness, and may then be planarized by applying CMP or other planarization step to the second non-photoimagable polyimide layer.

At step 114, a second photoresist and/or mask layer is formed over the second non-photoimagable polyimide layer after removing the first photoresist mask, where the second photoresist mask includes a patterned metal line etch opening which exposes a portion of the second non-photoimagable polyimide layer. In selected embodiments, the second photoresist mask is formed with any suitable photoresist/mask formation sequence.

At step 115, a laser irradiation source is selectively applied to a portion of the second non-photoimagable polyimide layer exposed by the second photoresist mask, thereby directly forming a graphene wiring line structure in the second non-photoimagable polyimide layer. In selected embodiments, the graphene wiring line structure extends down through at least the second non-photoimagable polyimide layer to make contact with the graphene via structure.

At step 116, the fabrication process flow ends, though it will be appreciated that additional back-end-of-line processing may occur to complete the fabrication of the integrated circuit structure, such as packaging, scribe cuts, die separation, testing, etc.

As described hereinabove, the present disclosure provides a mechanism for fabricating graphene interconnects through selective exposure of polyimide dielectric layers as part of an exceptionally planar BEOL flow which does not need special metal, barrier, or liner layers for graphene contacts, and which circumvents the most complex and costly BEOL operations while providing the highest known conductivity. In addition to reducing fabrication cost and complexity, the disclosed mechanism for integrating graphene interconnects provides advantages to reliability and yield by reducing or eliminating stress migration, electromigration, or plasma induced damage.

By now, it should be appreciated that there has been provided an integrated circuit and associated method of fabrication. In the disclosed methodology, an integrated circuit structure is provided that includes one or more polymer interlayer dielectric (ILD) layers formed over a first conductive wiring line layer. In selected embodiments, the integrated circuit structure is provided with a semiconductor substrate on which is formed a plurality of integrated circuit elements covered by an initial ILD layer and the one or more polymer ILD layers. In selected embodiments, the one or more polymer ILD lay includes one or more ultra low-k photosensitive polymer layers which respond to irradiation from a light source with a chemical reaction which may be used for an ion exchange to impregnate a suitable metal into the exposed portion of the one or more polymer ILD layers. In other selected embodiments, the one or more polymer ILD lay includes one or more non-photosensitive, carbon-containing polymer layers which respond to irradiation from a laser source to form the graphene interconnect structure directly from the exposed portion of the one or more non-photosensitive, carbon-containing polymer layers. The disclosed methodology also includes selectively processing an exposed portion of the one or more polymer ILD layers by applying irradiation from a laser or light source to form a graphene interconnect structure in the one or more polymer ILD layers which is directly, electrically connected to the first conductive wiring line layer. In selected embodiments, the exposed portion of the one or more polymer ILD layers is selectively processed by patterning a first resist material on one of the one or more polymer ILD layers to form a first resist mask with a via opening; selectively applying irradiation from a light source using the via opening of the first resist mask to selectively expose a first portion of the one or more polymer ILD layers where a graphene via from the graphene interconnect structure will be formed; patterning a second resist material on one of the one or more polymer ILD layers to form a second resist mask with a metal line opening; selectively applying irradiation from the light source using the metal line opening of the second resist mask to selectively expose a second portion of the one or more polymer ILD layers where a graphene wiring line from the graphene interconnect structure will be formed; applying a metal solution soak to the first and second portions of the one or more polymer ILD layers to form metal-polyimide structures; and performing a heat treatment to convert the metal-polyimide structures into the graphene interconnect structure. In other selected embodiments, the exposed portion of the one or more polymer ILD layers are selectively processed by patterning a first resist material on one of the one or more polymer ILD layers to form a first resist mask with a via opening; selectively applying irradiation from a laser source to a defined first portion of the one or more polymer ILD layers using the via opening of the first resist mask to directly form a graphene via structure which is directly, electrically connected to the first conductive wiring line layer; patterning a second resist material on one of the one or more polymer ILD layers to form a second resist mask with a metal line opening; and selectively applying irradiation from a laser source to a defined second portion of the one or more polymer ILD layers using the metal line opening of the second resist mask to directly form a graphene wiring line which is directly, electrically connected to the graphene via structure. In selected embodiments, the graphene interconnect structure includes a graphene wiring line layer connected to the first conductive line layer with a graphene via structure that positioned to completely cover a maximized overlapping region between the graphene wiring line layer and first conductive wiring line layer.

In another form, there has been provided a graphene interconnect structure and associated method of fabrication. In the disclosed methodology, a first conductive layer is formed over a first dielectric layer. In selected embodiments, the first conductive layer is formed with a first graphene layer on the first dielectric layer which covers a plurality of integrated circuit elements formed on a semiconductor substrate. The disclosed methodology also includes forming one or more polyimide dielectric layers over the first conductive layer. In addition, the disclosed methodology includes selectively applying irradiation to directly or indirectly convert the one or more polyimide dielectric layers into the graphene interconnect structure comprising a graphene wiring line formed in an upper portion of a first polyimide dielectric layer and a graphene via structure formed in the first polyimide dielectric layer to directly, electrically connect the graphene wiring line to the first conductive layer. In selected embodiments, the one or more polyimide dielectric layers are formed by depositing and planarizing an ultra-low-k photosensitive polymer dielectric layer which responds to irradiation from a light source with a chemical reaction which may be used for an ion exchange to impregnate a suitable metal into the exposed portion of ultra-low-k photosensitive polymer dielectric layer. In such embodiments, selective application of irradiation may include patterning a first resist material over the ultra-low-k photosensitive polymer dielectric layer to form a first resist mask with a via opening; selectively applying irradiation from a light source using the via opening of the first resist mask to selectively expose a first portion of the ultra-low-k photosensitive polymer dielectric layer where a graphene via from the graphene interconnect structure will be formed; patterning a second resist material over the ultra-low-k photosensitive polymer dielectric layer to form a second resist mask with a wiring line opening; selectively applying irradiation from the light source using the wiring line opening of the second resist mask to selectively expose a second portion of the ultra-low-k photosensitive polymer dielectric layer where a graphene wiring line from the graphene interconnect structure will be formed; applying a metal solution soak to the first and second portions of the ultra-low-k photosensitive polymer dielectric layer to form metal-polyimide structures; and performing a heat treatment to convert the metal-polyimide structures into the graphene interconnect structure. In other selected embodiments, the one or more polyimide dielectric layers are formed by depositing and planarizing a non-photosensitive, carbon-containing polymer dielectric layer which responds to irradiation from a laser source to form the graphene interconnect structure directly from the exposed portion of the non-photosensitive, carbon-containing polymer layer. In such embodiments, selective application of irradiation may include patterning a first resist material over the non-photosensitive, carbon-containing polymer dielectric layer to form a first resist mask with a via opening; selectively applying irradiation from a laser source to a defined first portion of the non-photosensitive, carbon-containing polymer dielectric layer using the via opening of the first resist mask to directly form a graphene via structure which is directly, electrically connected to the first conductive layer; patterning a second resist material over the non-photosensitive, carbon-containing polymer dielectric layer to form a second resist mask with a wiring line opening; and selectively applying irradiation from the laser source to a defined second portion of the non-photosensitive, carbon-containing polymer dielectric layer using the wiring line opening of the second resist mask to directly form a graphene wiring line which is directly, electrically connected to the graphene via structure. In other embodiments, irradiation is selectively applied by a femto-second UV laser source to directly convert the one or more polyimide dielectric layers into the graphene interconnect structure. In selected embodiments, the graphene interconnect structure includes a graphene wiring line connected to the first conductive layer with a graphene via structure that positioned to completely cover a maximized overlapping region between the graphene wiring line and the first conductive layer. In other embodiments, the graphene wiring line and graphene via structure each include a laser-induced graphene foam structure. In selected embodiments, the disclosed methodology also includes planarizing the graphene wiring line with a top surface of the one or more polyimide dielectric layers. In other selected embodiments, the graphene wiring line and graphene via structure are each formed as a heat-treated mixture of nickel and polyimide which is formed from a light-induced ion exchange reaction of nickel and polyimide.

In yet another form, there has been provided a integrated circuit and associated method of fabrication. As disclosed, the integrated circuit includes a substrate having one or more semiconductor devices formed therein. In addition, the semiconductor device includes a multi-layer graphene interconnect stack formed over the substrate to include a plurality of stacked graphene wiring lines that are vertically separated from one another by a corresponding plurality of polyimide interlayer dielectric (ILD) layers. In particular, the multi-layer graphene interconnect stack includes a first graphene wiring line in a first conductor layer, a second graphene wiring line in a second conductor layer that is separated from the first graphene wiring line by a first polyimide ILD layer, and a first graphene via structure formed in the first polyimide ILD layer to electrically connect the first graphene wiring line to the second graphene wiring line. Each of the first graphene wiring line, second graphene wiring line, and first graphene via structure are formed as a graphene foam structure which does not include an underlying metal layer. In selected embodiments, the first graphene wiring line, second graphene wiring line, and first graphene via structure are each formed as a laser-induced graphene foam structure.

Although the described exemplary embodiments disclosed herein are directed to various semiconductor and integrated circuit device structures and methods for making the same, the present invention is not necessarily limited to the example embodiments which illustrate inventive aspects of the present invention that are applicable to a wide variety of semiconductor processes and/or devices. Thus, the particular embodiments disclosed above are illustrative only and should not be taken as limitations upon the present invention, as the invention may be modified and practiced in different but equivalent manners apparent to those skilled in the art having the benefit of the teachings herein. Accordingly, the foregoing description is not intended to limit the invention to the particular form set forth, but on the contrary, is intended to cover such alternatives, modifications and equivalents as may be included within the spirit and scope of the invention as defined by the appended claims so that those skilled in the art should understand that they can make various changes, substitutions and alterations without departing from the spirit and scope of the invention in its broadest form.

Benefits, other advantages, and solutions to problems have been described above with regard to specific embodiments. However, the benefits, advantages, solutions to problems, and any element(s) that may cause any benefit, advantage, or solution to occur or become more pronounced are not to be construed as a critical, required, or essential feature or element of any or all the claims. As used herein, the terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus.

## Claims

1. A method for making an integrated circuit, comprising:
providing an integrated circuit structure comprising one or more polymer interlayer dielectric, ILD, layers formed over a first conductive wiring line layer; and
selectively processing an exposed portion of the one or more polymer ILD layers by applying irradiation from a laser or light source to form a graphene interconnect structure in the one or more polymer ILD layers which is directly, electrically connected to the first conductive wiring line layer.

2. The method of claim 1, where providing the integrated circuit structure comprises providing a semiconductor substrate on which is formed a plurality of integrated circuit elements covered by an initial ILD layer and the one or more polymer ILD layers.

3. The method of claim 1 or 2, where the one or more polymer ILD lay comprises one or more ultra low-k photosensitive polymer layers which respond to irradiation from a light source with a chemical reaction which may be used for an ion exchange to impregnate a suitable metal into the exposed portion of the one or more polymer ILD layers.

4. The method of any preceding claim, where the one or more polymer ILD lay comprises one or more non-photosensitive, carbon-containing polymer layers which respond to irradiation from a laser source to form the graphene interconnect structure directly from the exposed portion of the one or more non-photosensitive, carbon-containing polymer layers.

5. The method of any preceding claim, where selectively processing the exposed portion of the one or more polymer ILD layers comprises:
patterning a first resist material on one of the one or more polymer ILD layers to form a first resist mask with a via opening;
selectively applying irradiation from a light source using the via opening of the first resist mask to selectively expose a first portion of the one or more polymer ILD layers where a graphene via from the graphene interconnect structure will be formed;
patterning a second resist material on one of the one or more polymer ILD layers to form a second resist mask with a metal line opening;
selectively applying irradiation from the light source using the metal line opening of the second resist mask to selectively expose a second portion of the one or more polymer ILD layers where a graphene wiring line from the graphene interconnect structure will be formed;
applying a metal solution soak to the first and second portions of the one or more polymer ILD layers to form metal-polyimide structures; and
performing a heat treatment to convert the metal-polyimide structures into the graphene interconnect structure.

6. The method of any preceding claim, where selectively processing the exposed portion of the one or more polymer ILD layers comprises:
patterning a first resist material on one of the one or more polymer ILD layers to form a first resist mask with a via opening;
selectively applying irradiation from a laser source to a defined first portion of the one or more polymer ILD layers using the via opening of the first resist mask to directly form a graphene via structure which is directly, electrically connected to the first conductive wiring line layer;
patterning a second resist material on one of the one or more polymer ILD layers to form a second resist mask with a metal line opening; and
selectively applying irradiation from a laser source to a defined second portion of the one or more polymer ILD layers using the metal line opening of the second resist mask to directly form a graphene wiring line which is directly, electrically connected to the graphene via structure.

7. The method of any preceding claim, where the graphene interconnect structure comprises a graphene wiring line layer connected to the first conductive wiring line layer with a graphene via structure that positioned to completely cover a maximized overlapping region between the graphene wiring line layer and first conductive wiring line layer.

8. A method for forming a graphene interconnect structure, comprising:
forming a first conductive layer over a first dielectric layer;
forming one or more polyimide dielectric layers over the first conductive layer;
selectively applying irradiation to convert the one or more polyimide dielectric layers into the graphene interconnect structure comprising a graphene wiring line formed in an upper portion of a first polyimide dielectric layer and a graphene via structure formed in the first polyimide dielectric layer to directly, electrically connect the graphene wiring line to the first conductive layer.

9. The method of claim 8, where forming the first conductive layer comprises forming a first graphene layer on the first dielectric layer which covers a plurality of integrated circuit elements formed on a semiconductor substrate.

10. The method of claim 8 or 9, where forming one or more polyimide dielectric layers comprises depositing and planarizing an ultra-low-k photosensitive polymer dielectric layer which responds to irradiation from a light source with a chemical reaction which may be used for an ion exchange to impregnate a suitable metal into the exposed portion of ultra-low-k photosensitive polymer dielectric layer.

11. The method of claim 10, where selectively applying irradiation comprises:
patterning a first resist material over the ultra-low-k photosensitive polymer dielectric layer to form a first resist mask with a via opening;
selectively applying irradiation from a light source using the via opening of the first resist mask to selectively expose a first portion of the ultra-low-k photosensitive polymer dielectric layer where a graphene via from the graphene interconnect structure will be formed;
patterning a second resist material over the ultra-low-k photosensitive polymer dielectric layer to form a second resist mask with a wiring line opening;
selectively applying irradiation from the light source using the wiring line opening of the second resist mask to selectively expose a second portion of the ultra-low-k photosensitive polymer dielectric layer where a graphene wiring line from the graphene interconnect structure will be formed;
applying a metal solution soak to the first and second portions of the ultra-low-k photosensitive polymer dielectric layer to form metal-polyimide structures; and
performing a heat treatment to convert the metal-polyimide structures into the graphene interconnect structure.

12. The method of any of claims 8 to 11, where forming one or more polyimide dielectric layers comprises depositing and planarizing a non-photosensitive, carbon-containing polymer dielectric layer which responds to irradiation from a laser source to form the graphene interconnect structure directly from the exposed portion of the non-photosensitive, carbon-containing polymer layer.

13. The method of claim 12, where selectively applying irradiation comprises:
patterning a first resist material over the non-photosensitive, carbon-containing polymer dielectric layer to form a first resist mask with a via opening;
selectively applying irradiation from a laser source to a defined first portion of the non-photosensitive, carbon-containing polymer dielectric layer using the via opening of the first resist mask to directly form a graphene via structure which is directly, electrically connected to the first conductive layer;
patterning a second resist material over the non-photosensitive, carbon-containing polymer dielectric layer to form a second resist mask with a wiring line opening; and
selectively applying irradiation from the laser source to a defined second portion of the non-photosensitive, carbon-containing polymer dielectric layer using the wiring line opening of the second resist mask to directly form a graphene wiring line which is directly, electrically connected to the graphene via structure.

14. An integrated circuit, comprising:
a substrate comprising one or more semiconductor devices formed therein; and
a multi-layer graphene interconnect stack formed over the substrate comprising a plurality of stacked graphene wiring lines that are vertically separated from one another by a corresponding plurality of polyimide interlayer dielectric (ILD) layers, the multi-layer graphene interconnect stack comprising:
a first graphene wiring line in a first conductor layer,
a second graphene wiring line in a second conductor layer that is separated from the first graphene wiring line by a first polyimide ILD layer, and
a first graphene via structure formed in the first polyimide ILD layer to electrically connect the first graphene wiring line to the second graphene wiring line;
where the first graphene wiring line, second graphene wiring line, and first graphene via structure each comprise a graphene foam structure which does not include an underlying metal layer.

15. The integrated circuit of claim 19, where the first graphene wiring line, second graphene wiring line, and first graphene via structure each comprise a laser-induced graphene foam structure.
